# EUROPEAN PATENT APPLICATION

(11) **EP 4 318 662 A1**
(43) Date of publication of application: **07.02.2024**
(21) Application number: 22938761.8
(22) Date of filing: 25.04.2022
(51) Int. Cl.: H01M 4/505

(54) **SPINEL LITHIUM NICKEL MANGANESE OXIDE MATERIAL AND PREPARATION METHOD THEREFOR**

(71) Applicant: Contemporary Amperex Technology Co., Limited, Ningde, Fujian 352100 (CN)
(72) Inventor: FAN, Jingpeng, Ningde, Fujian 352100 (CN); ZHANG, Zhenguo, Ningde, Fujian 352100 (CN); LIU, Na, Ningde, Fujian 352100 (CN); WU, Qi, Ningde, Fujian 352100 (CN); CHEN, Qiang, Ningde, Fujian 352100 (CN); ZHAO, Dong, Ningde, Fujian 352100 (CN); WANG, Jing, Ningde, Fujian 352100 (CN)
(74) Representative: Gong, Jinping
(86) International application number: PCT/CN2022/088926
(87) International publication number: WO 2023/205993

(57) **Abstract**

The present disclosure provides a spinel lithium nickel manganese oxide material, in which an XRD pattern of the spinel lithium nickel manganese oxide material satisfies: 0 < (A(43.7°)/A(18.8°))^{1/2} ≤ 0.2. The spinel lithium nickel manganese oxide material disclosed by the present disclosure can reduce oxygen defects, enhance stability of a crystal structure and reduce content of a rock salt phase.

## Description

### TECHNICAL FIELD

The present disclosure relates to the field of electrochemistry, and in particular, to a spinel lithium nickel manganese oxide material and a preparation method thereof.

### BACKGROUND

A discharge voltage platform of spinel lithium nickel manganese oxide is as high as 4.7V(vs Li/Li⁺), and a theoretical discharge specific capacity is relatively high (147mAh/g), so that the spinel lithium nickel manganese oxide has a relatively high theoretical specific energy density (690Wh/kg). Currently, the spinel lithium nickel manganese oxide actually used in a graphite negative electrode full battery has also a specific energy density higher than 590Wh/kg, which is far higher than that of lithium iron phosphate (≤460Wh/kg) and close to that of ternary nickel cobalt manganese (≥650Wh/kg), and the spinel lithium nickel manganese oxide still has a large improving space. The spinel lithium nickel manganate oxide has contents of Li and Ni remarkably lower than that in the ternary nickel cobalt manganese, and has a simple preparation process, so when being used in the graphite negative electrode full battery, cost of a unit watt-hour of the battery is far lower than that of the ternary nickel cobalt manganese and close to that of the lithium iron phosphate. Furthermore, the spinel lithium nickel manganese oxide is high in thermal stability and large in allowable overcharge and overdischarge amplitudes, so safety of a system using the spinel lithium nickel manganese oxide is obviously superior to that of a system using the ternary nickel cobalt manganese.

In conclusion, the spinel lithium nickel manganese oxide has a high energy density, a low cost and a high safety, and thus it is a very potential low-cost high-energy-density positive electrode material.

However, this material itself has following defects, which seriously affects its application in a battery cell:

Synthesizing the spinel lithium nickel manganese oxide under a high-temperature condition will easily result in oxygen deficiency of the material, so as to cause a large amount of oxygen defects and a rock salt phase, thereby leading to reduction of structural stability of the material, and then causing a cycle performance to become poor.

Moreover, under a high-temperature and high-pressure operating condition, in the spinel lithium nickel manganate oxide, it is easy for the Mn³⁺ to experience disproportionation reaction, Mn²⁺ is dissolved in electrolyte-solution and deposited at a negative electrode, and meanwhile, a large number of side reactions occur between a surface of the material and the electrolyte, causing an overall performance of the battery to deteriorate.

Therefore, present research focuses on reducing the oxygen defect of the spinel lithium nickel manganese oxide, enhancing the stability of the crystal structure and reducing the content of the rock salt phase, thereby improving a rate performance, a cycle performance and a storage performance of the positive electrode material, thus improving an energy density and a long cycle life of the battery using the positive electrode material.

### SUMMARY

In view of the technical problems above, the present disclosure aims to provide a spinel lithium nickel manganese oxide material and a preparation method thereof, a secondary battery with the spinel lithium nickel manganese oxide material, a battery module, a battery pack and an electric device. The spinel lithium nickel manganese oxide material of the present disclosure can reduce oxygen defects, enhance stability of the crystal structure and reduce the content of the rock salt phase.

In order to achieve the aim above, a first aspect of the present disclosure provides a spinel lithium nickel manganese oxide material. An X-ray diffraction (XRD) pattern of the spinel lithium nickel manganese oxide material satisfies: 0 < (A(43.7°)/A(18.8°))^{1/2} ≤ 0.2, preferably, satisfies: 0<(A(43.7°)/A(18.8°))^{1/2} ≤ 0.1, where A(43.7°) represents a peak area of a diffraction peak appearing in the vicinity of 43.7° in the XRD pattern, and A(18.8°) represents a peak area of a diffraction peak appearing in the vicinity of 18.8° in the XRD pattern.

By determining a relationship between a specific range of (A(43.7°)/A(18.8°))^{1/2} in the XRD pattern of the spinel lithium nickel manganese oxide material and the oxygen defect, reduction of the oxygen defect of the spinel lithium nickel manganese oxide material can be determined by measuring the XRD pattern of the spinel lithium nickel manganate oxide material.

In some embodiments, a stoichiometric formula of the spinel lithium nickel manganese oxide material is Liₓ(Ni_{0.5}Mn_{1.5})ₙMₘO₄, where M is one or more elements selected from W, P, B, Nb, Mo or Ta, and as stoichiometric numbers, n + m = 1, x is in a range from 0.95 to 1.1, and m is in a range from 0.001 to 0.015. The stoichiometric range is achieved by doping one or more elements selected from W, P, B, Nb, Mo or Ta to the spinel lithium nickel manganate oxide, so that the crystal structure of the obtained spinel lithium nickel manganate oxide material satisfies the condition of (A(43.7°)/A(18.8°))^{1/2} within the specific range, thereby determining the reduction of the oxygen defects in the crystal structure.

In some embodiments, the spinel lithium nickel manganese oxide material is a single crystal of an octahedron with corners of obtuse angles. Through modifying the spinel lithium nickel manganese oxide by doping the element above in a specific amount, the obtained spinel lithium nickel manganese oxide material forms the single crystal morphology of the octahedron corners of obtuse angles, and the corners of obtuse angles can reduce surface activity of the spinel lithium nickel manganese oxide and reduce a contact area with electrolyte-solution, so as to reduce side reactions; and the single crystal morphology can effectively reduce a cracking phenomenon in cold pressing and using process of a battery cell, to improve an overall performance of the battery cell.

In some embodiments, a volume distribution average particle size Dv50 of the spinel lithium nickel manganese oxide material is in a range from 5µm to 15µm, and preferably in a range from 5µm to 10µm. By setting the volume distribution average particle size Dv50 of the nickel manganese spinel material disclosed by the present disclosure within the range above, the side reactions of the nickel manganese spinel material and the electrolyte-solution can be effectively reduced due to the fact that the particle size of primary particles is relatively large.

In some embodiments, a particle volume distribution span (Dv90-Dv10)/Dv50 of the spinel lithium nickel manganese oxide material is 1.0 or less. By setting the (Dv90-Dv10)/Dv50 of the nickel manganese spinel material within the above range, the side reactions of the nickel manganese spinel material and the electrolyte-solution can be effectively reduced due to good particle consistency.

In some embodiments, a BET specific surface area of the nickel manganese spinel material is in a range from 0.3m²/g to 1.0m²/g, and preferably in a range from 0.3m²/g to 0.5m²/g. By setting the BET specific surface area of the nickel manganese spinel material disclosed by the present disclosure, the side reactions between the nickel manganese spinel material and the electrolyte-solution can be effectively reduced since the BET specific surface area is small.

A second aspect of the present disclosure provides a preparation method of the spinel lithium nickel manganese oxide material involved in the first aspect.

The preparation method includes: step S1: putting a lithium salt, a nickel manganese hydroxide precursor and an M-containing compound into a mixer for mixing to obtain a mixed material; step S2: heating the mixed material obtained in the step S1 in an oxygen-enriched atmosphere for first sintering, naturally cooling to a room temperature after the first sintering is finished, and then carrying out ball milling to obtain a powder; and step S3: heating the powder obtained in the step S2 in an oxygen-enriched atmosphere again for second sintering, holding a temperature after the second sintering is finished, then naturally cooling to the room temperature, and then carrying out ball milling to obtain the spinel lithium nickel manganate oxide material.

The spinel lithium nickel manganese oxide material obtained by the preparation method above has less oxygen defects, side reactions and Mn dissolution, and thus has excellent comprehensive electrochemical properties.

In some embodiments, in the step S1, the lithium salt and the nickel manganese hydroxide are mixed in a molar ratio of Li/(Ni+Mn) of (0.45 to 0.55): 1, where (Ni + Mn) represents a total number of moles of metals nickel and manganese, and the M-containing compound is doped in an amount according to a molar ratio of Li/M of 1:(0.001 to 0.01), and preferably a molar ratio of Li/M of 1:(0.003 to 0.007). By setting the doping amount of the M-containing compound within the range above and setting the mixing ratio of the lithium salt to the nickel manganese hydroxide within the range above, the crystal morphology of the spinel lithium nickel manganese oxide material can be effectively regulated and controlled, thereby effectively reducing the oxygen defect, effectively reducing the side reactions of the spinel lithium nickel manganese oxide material and the electrolyte-solution, improving the structural stability of the spinel lithium nickel manganese oxide material, and reducing Mn dissolution.

In some embodiments, in the step S1, the mixer is a ploughshare mixer, a high-speed mixer or an inclined mixer. By using these mixers, mixing efficiency can be effectively improved.

In some embodiments, in the step S2 and the step S3, a heating rate during the first sintering and the second sintering is 5°C/min or lower, and preferably 3°C/min or lower. Due to the fact that the heating rate affects a heating condition of the material in a crystallization process, it is guaranteed that primary particles are more uniform by setting the heating rate to be within the range.

In some embodiments, in the step S2, the first sintering is carried out at a temperature in a range from 500°C to 1200°C, and preferably, in a range from 600°C to 1200°C, and in the step S3, the second sintering is carried out at a temperature in a range from 400°C to 700°C, and preferably, in a range from 500°C to 700°C. Through the two sintering, the second sintering annealing of the spinel lithium nickel manganese oxide material can compensate for oxygen defects in the first sintering annealing process, and the oxygen defect of the material is further reduced, meanwhile, the content of Mn³⁺ in the material is effectively reduced, and Mn dissolution is reduced. Since the spinel lithium nickel manganese oxide is doped with one or more elements selected from W, P, B, Nb, Mo or Ta, the first sintering and the second sintering can be carried out at a temperature within relatively low temperature ranges respectively to perform synthetization.

In some embodiments, in the step S2 and the step S3, the oxygen content of the oxygen-enriched atmosphere is higher than 60%, and preferably in a range from 80% to 100%. By setting the oxygen-enriched atmosphere within the range above, the content of small particles in the spinel lithium nickel manganese oxide material can be effectively reduced, and meanwhile, the content of the oxygen defect of the spinel lithium nickel manganese oxide material is reduced.

In some embodiments, in the step S2 and the step S3, a pressure in a sintering furnace relative to an atmospheric pressure is in a range from 0.02MPa to 0.08MPa, and preferably in a range from 0.02MPa to 0.04MPa. By setting the pressure in the sintering furnace relative to the atmospheric pressure to be within the range above, the content of small particles in the spinel lithium nickel manganese oxide material can be effectively reduced, and meanwhile, the content of the oxygen defect of the spinel lithium nickel manganese oxide material is reduced.

In some embodiments, in the step S3, a duration for holding the temperature is in a range from 5 hours to 40 hours, and preferably in a range from 15 hours to 30 hours. By setting the duration for holding the temperature to be within the range above, the oxygen defect of the material can be further reduced, and meanwhile, the content of Mn³⁺ in the material is effectively reduced, and Mn dissolution is reduced.

A third aspect of the present disclosure provides a secondary battery, and the secondary battery includes the spinel lithium nickel manganese oxide material according to the first aspect of the present disclosure.

A fourth aspect of the present disclosure provides a battery module, and the battery module includes the secondary battery according to the third aspect of the present disclosure.

A fifth aspect of the present disclosure provides a battery pack, and the battery pack includes the battery module according to the fourth aspect of the present disclosure.

A sixth aspect of the present disclosure provides an electric device, and the electric device includes at least one of the secondary battery according to the third aspect of the present disclosure, the battery module according to the fourth aspect of the present disclosure or the battery pack according to the fifth aspect of the present disclosure.

The spinel lithium nickel manganese oxide material is used as a positive electrode material, and the spinel lithium nickel manganese oxide material is low in content of the oxygen defect, high in stability of the crystal structure and low in content of the rock salt phase, so that the secondary battery using the positive electrode material has a high energy density and a long cycle life, and a gas production problem in a cycle process is effectively inhibited.

### BRIEF DESCRIPTION OF DRAWINGS

FIG. 1a, FIG. 1b and FIG. 1c are XRD patterns of a spinel lithium nickel manganese oxide material according to an embodiment of the present disclosure.
FIG. 2a and FIG. 2b are SEM images of particles of a spinel lithium nickel manganese oxide material according to another embodiment of the present disclosure.
FIG. 3 is a schematic diagram of a secondary battery according to an embodiment of the present disclosure.
FIG. 4 is an exploded diagram of the secondary battery according to an embodiment of the present disclosure shown in FIG. 3.
FIG. 5 is a schematic diagram of a battery module according to an embodiment of the present disclosure.
FIG. 6 is a schematic diagram of a battery pack according to an embodiment of the present disclosure.
FIG. 7 is an exploded diagram of the battery pack according to an embodiment of the present disclosure shown in FIG. 6.
FIG. 8 is a schematic diagram of an electric device using a secondary battery as a power supply according to an embodiment of the present disclosure.
FIG. 9a, FIG. 9b and FIG. 9c show XRD patterns of a spinel lithium nickel manganese oxide material according to Embodiment 1 of the present disclosure.
FIG. 10a, FIG. 10b and FIG. 10c show XRD patterns of a spinel lithium nickel manganese oxide material according to Comparative Example 1 of the present disclosure.
FIG. 11a and FIG. 11b show SEM images of a spinel lithium nickel manganese oxide material doped with Zr according to Comparative Example 11 of the present disclosure.
FIG. 12a and FIG. 12b show SEM images of a spinel lithium nickel manganese oxide material without doping.

### DESCRIPTION OF SIGNS OF THE DRAWINGS:

1 battery pack; 2 upper box body; 3 lower box body; 4 battery module; 5 secondary battery; 51 housing; 52 electrode assembly; and 53 top cover assembly

### DESCRIPTION OF EMBODIMENTS

Embodiments of a positive electrode plate, a secondary battery, a battery module, a battery pack, and an electric device of the present disclosure are described in detail below with reference to the accompanying drawings. However, unnecessary detailed description may be omitted. For example, there is a case of omitting a detailed description of well-known items and a repeated description of an actually same structure. This is to avoid the following description to be unnecessarily lengthy, thereby making it convenient for those skilled in the art to understand. In addition, the accompany drawings and the following description are provided to make those skilled in the art to fully understand the present disclosure, which is not intended to limit the subject matter recited in the claims.

A "range" disclosed herein is defined in a form of a lower limit and an upper limit, and a given range is defined by selecting one lower limit and one upper limit, while the selected lower limit and upper limit define boundaries of a particular range. A range defined in this manner may include or do not include an end value, which may be arbitrarily combined, that is, any lower limit may be combined with any upper limit to form a range. For example, if ranges of 60 to 120 and 80 to 110 are listed for a particular parameter, it is understood that ranges of 60 to 110 and 80 to 120 are also expected. Further, if minimum range values 1 and 2 are listed, and maximum range values 3, 4, and 5 are listed, then following ranges may all be expected: 1 to 3, 1 to 4, 1 to 5, 2 to 3, 2 to 4, and 2 to 5. In the present disclosure, unless otherwise indicated, a numerical range "a to b" means an abbreviated representation of a combination of any real numbers from a to b, where a and b are both real numbers. For example, a numerical range "0 to 5" means that all real numbers between "0 to 5" are all listed herein, and "0 to 5" is merely an abbreviated representation of a combination of these numbers. In addition, when it is expressed that a certain parameter is an integer which is ≥ 2, it is equivalent to disclosing that the parameter is, for example, an integer 2, 3, 4, 5, 6, 7, 8, 9, 10, 11, 12, etc.

If not specifically indicated, all embodiments and optional embodiments of the present disclosure may be combined with each other to form a new technical solution.

If not specifically indicated, all technical features and optional technical features of the present disclosure may be combined with each other to form a new technical solution.

If not specifically indicated, "include" and "comprise" mentioned in the present disclosure represent an open type or may be a closed type. For example, the "include" and "comprise" may indicate that other un-listed components can be further included or comprised, or only listed components are included or comprised.

If not specifically indicated, a term "or" is inclusive in the present disclosure. For example, a phrase "A or B" means "A only, B only, or both A and B". More specifically, any of following conditions satisfy the condition "A or B": A is true (or present) and B is false (or not present); A is false (or not present) and B is true (or present); or both A and B are true (or present).

### Spinel Lithium Nickel Manganese Oxide Material

An X-ray diffraction (XRD) pattern of the spinel lithium nickel manganese oxide material disclosed by the present disclosure satisfies: 0 < (A(43.7°)/A(18.8°))^{1/2} ≤ 0.2, and preferably satisfies: 0 < (A(43.7°)/A(18.8°))^{1/2} ≤ 0.1, where A(43.7°) represents a peak area of a diffraction peak appearing in the vicinity of 43.7° in the XRD pattern, and A(18.8°) represents a peak area of a diffraction peak appearing in the vicinity of 18.8° in the XRD pattern.

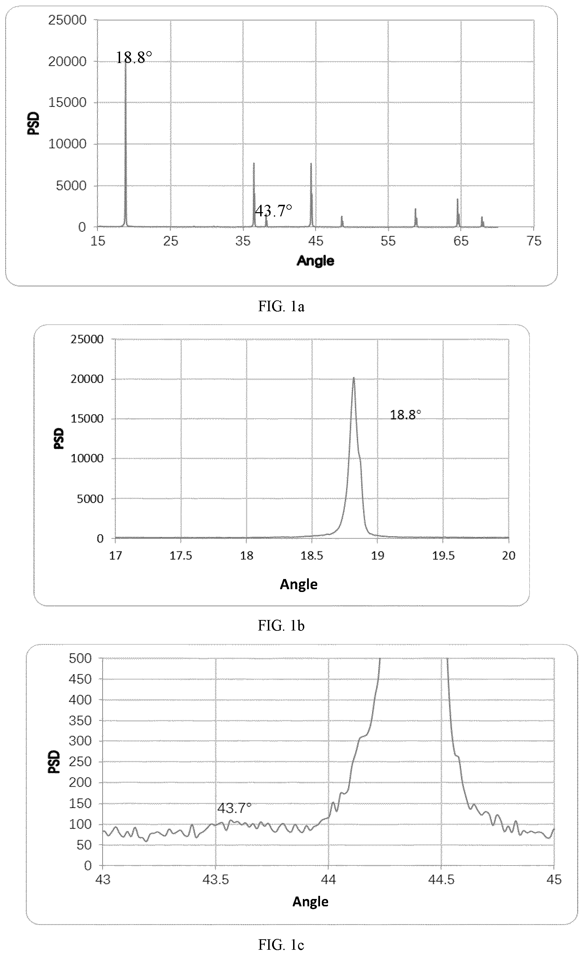

As shown in FIG. 1a, FIG. 1b and FIG. 1c, the spinel lithium nickel manganese oxide material disclosed by the present disclosure has a diffraction peak in the vicinity of 43.7° and a diffraction peak in the vicinity of 18.8°, so that the peak area of the diffraction peak appearing in the vicinity of 43.7° and the peak area of the diffraction peak appearing in the vicinity of 18.8° can be obtained, and then the (A(43.7°)/A(18.8°))^{1/2} of the spinel lithium nickel manganese oxide material is calculated.

When the spinel lithium nickel manganese oxide (LiNi_{0.5}Mn_{1.5}O₄) is heated to be above a certain temperature, LiNi_{0.5}Mn_{1.5}O₄ will lose oxygen and be disproportionated into spinel and LiₓNi₁₋ₓO, and a reaction is as follows: LiNi_{0.5}Mn_{1.5}0₄→αLiₓNi₁₋ₓO+βLiNi_{0.5}+yMn_{1.5}O₄+γO₂, LiₓNi₁₋ₓO belongs to a rock salt phase, and has a section of peak expression at 2θ=37.6°, 43.7° and 63.5° in the XRD pattern, and it can be known from this chemical formula that the more the rock salt phase is, the more the oxygen deficit is, and the larger the oxygen defect is, so that the diffraction peak expression at 2θ=37.6°, 43.7° and 63.5° in the XRD pattern can be expressed as content of the oxygen defect, and diffraction peak intensity at 37.6° and 63.5° is extremely low, so that the case of 43.7° is used to define the content of the oxygen defect. In addition, a reference peak is defined by the case of 18.8°.

In addition, a stoichiometric formula of the spinel lithium nickel manganese oxide material disclosed by the present disclosure is Liₓ(Ni_{0.5}Mn_{1.5})ₙMₘO₄, where M is one or more elements selected from W, P, B, Nb, Mo, or Ta, and as stoichiometric numbers, n + m = 1, x is in a range from 0.95 to 1.1, and m is in a range from 0.001 to 0.015.

More than one element selected from W, P, B, Nb, Mo or Ta is used as a doping element to lower a synthesis temperature, to reduce the reaction above, so as to reduce the oxygen defect thereof; and in the stoichiometric formula above, a doping amount is controlled to be proper, and if the doping amount is too low, the effect is low, while a too high doping amount will influence capacity utilization of the spinel lithium nickel manganese oxide material.

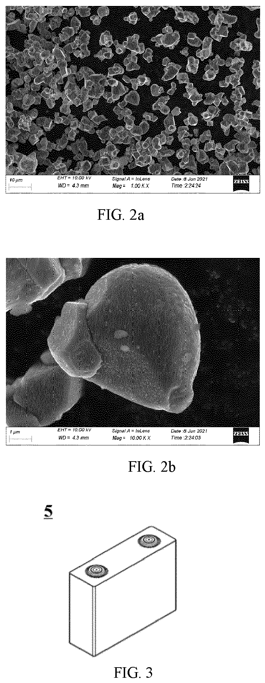

The doping element M can effectively influence morphology of the particles, so that corners of a perfect octahedron are with obtuse angles, and as shown in FIGS. 2a and 2b, it is proved that the spinel lithium nickel manganate oxide material is single crystal and has a morphology characteristic of the octahedron with corners of obtuse angles.

Furthermore, a volume distribution average particle size Dv50 of the spinel lithium nickel manganese oxide material is in a range from 5µm to 15µm, and preferably in a range from 5µm to 10µm. The size of the Dv50 mainly influence a contact surface of the material with the electrolyte-solution, so as to influence side reaction of the material and the electrolyte-solution, but the size of the Dv50 is influenced by the temperature for the first sintering and the temperature for the second sintering. As the temperature increases, the Dv50 is increased accordingly, so the relatively large Dv50 needs to be synthesized at a relatively high temperature, but if the temperature increases, the oxygen defect thereof will be increased accordingly, so that the Dv50 is limited not to be too large, while if the Dv50 is too small, relatively large side reaction will be caused, to result in deterioration of the electrical property.

Furthermore, a particle volume distribution span (Dv90-Dv10)/Dv50 of the spinel lithium nickel manganese oxide material is 1.0 or less. The particle volume distribution span (Dv90- Dv10)/Dv50 represents a size difference among the particles in the material, and the smaller the difference is, the smaller this value is. Moreover, the value mainly affects the side reaction of the material and the electrolyte-solution.

Furthermore, a BET specific surface area of the nickel manganese spinel material is in a range from 0.3m²/g to 1.0m²/g, and preferably in a range from 0.3m²/g to 0.5m²/g. The BET specific surface area mainly affects the capacity utilization and the side reaction of the spinel lithium nickel manganese oxide material, and relatively large BET specific surface area can provide relatively high capacity, but the side reaction thereof will be increased, so that the BET specific surface area should be limited to be not too large or too small. Furthermore, coating of the BET specific surface area on the spinel lithium nickel manganese oxide material will also influence the capacity and the side reaction.

### Preparation Method of Spinel Lithium Nickel Manganese Oxide Material

The preparation method disclosed by the present disclosure includes steps S1 to S3 below:
S1, putting a lithium salt, a nickel manganese hydroxide precursor and an M-containing compound into a mixer for mixing to obtain a mixed material;
S2, heating the mixed material obtained in the step S1 in an oxygen-enriched atmosphere for first sintering, and after the first sintering is finished, naturally cooling to a room temperature, and then carrying out ball milling to obtain a powder; and
S3, heating the powder obtained in the step S2 in an oxygen-enriched atmosphere again for second sintering, and after the second sintering is finished, holding the temperature, then naturally cooling to the room temperature, and then carrying out ball milling to obtain the spinel lithium nickel manganate oxide material.

The spinel lithium nickel manganese oxide material obtained by the preparation method above in the present disclosure has less oxygen defects, side reactions and Mn dissolution, thereby having an excellent comprehensive electrochemical performance.

In the step S1 of the preparation method provided by the present disclosure, the lithium salt and the nickel manganese hydroxide are mixed in a molar ratio of Li/(Ni+Mn) of (0.45 to 0.55): 1, where (Ni + Mn) represents a total number of moles of metals nickel and manganese, and the M-containing compound is doped in an amount according to a molar ratio of Li/M of 1:(0.001 to 0.01), and preferably according to a molar ratio of Li/M of 1:(0.003 to 0.007).

The lithium salt may be lithium carbonate, lithium hydroxide. The nickel manganese hydroxide may be Ni_{0.5}Mn_{1.5}(OH)₇. The M-containing compound may be M-containing chloride, M-containing carbonate, M-containing sulfate, and the like, namely chloride, carbonate and sulfate of elements such as W, P, B, Nb, Mo and Ta.

Furthermore, by setting the doping amount of the M-containing compound within a range of the molar ratio of the Li/M, and setting a mixing ratio of the lithium salt to the nickel manganese hydroxide within a range of the molar ratio of the Li/(Ni + Mn), the doping element M entering a crystal lattice will occupy a position and vacancy of the transition metal, which can effectively reduce dissolution of the transition metal Mn in the material and the stability of a material structure, and these two are positively correlated, but an excessive doping amount of M will greatly influence an electrical property of the material, and the effect cannot be reflected if the doping amount is too small.

Meanwhile, the selected doping element can effectively increase growth of primary particles, so that the material can be carried out with second sintering at a relatively low temperature, and existence of the oxygen defects can be effectively reduced at a relatively low temperature for the second sintering.

In the step S1 of the preparation method disclosed by the present disclosure, the mixer can adopt a mixer commonly used in the art, and for example specifically, a ploughshare mixer, a high-speed mixer or an inclined mixer.

In some embodiments, in the step S2 and the step S3, a heating rate during sintering is 5°C/min or less, and preferably 3°C/min or less. Control of the heating rate can result in that various particles can be heated more uniformly in the growth process, so that the volume distribution span (Dv90-Dv10)/Dv50 is smaller, and the Dv50 is mainly related to the doping element and the temperature for the first primary sintering.

In some embodiments, in the step S2, the first sintering is carried out at a temperature in a range from 500 to 1200°C, and preferably in a range from 600 to 1200°C, and in the step S3, the second sintering is carried out at a temperature in a range from 400 to 700°C, and preferably in a range from 500 to 700°C. The first sintering in the step S2 is a crystallization process of the spinel lithium nickel manganese oxide material, and the morphology, Dv50 and electrical property of the spinel lithium nickel manganese oxide material are basically shaped in the step S2, but the relatively high temperature in the first sintering process will cause the oxygen defect to be increased. Furthermore, the second sintering in the step S3 is an annealing process of the spinel lithium nickel manganese oxide material, so that the oxygen defect caused by the first sintering process in the step S2 can be compensated, and the performance of the spinel lithium nickel manganese oxide material is further improved.

In some embodiments, in the step S2 and the step S3, an oxygen content of the oxygen-enriched atmosphere is higher than 60%, and preferably in a range from 80% to 100%. Since the oxygen-rich condition will influence the content of the oxygen defect of the material, the oxygen content needs to be controlled to be within the range above.

In some embodiments, in the step S2 and the step S3, a pressure in a sintering furnace relative to the atmospheric pressure is in a range from 0.02MPa to 0.08MPa, and preferably in a range from 0.02MPa to 0.04MPa. Too large or too small in-furnace pressure will cause the material to produce a large number of small particles, resulting in a relatively small Dv50 and a relatively large particle volume distribution span (Dv90-Dv10)/Dv50, and airflow exchange is influenced to lead to an increase in content of the oxygen defect.

In some embodiments, in the step S3, a duration for holding the temperature is in a range from 5h to 40h, and preferably in a range from 15h to 30h. The temperature for the second sintering is related to the duration for holding the temperature, carrying out the second sintering within the range in the step S3 can effectively reduce the oxygen defect and the content of Mn³⁺ of the spinel lithium nickel manganese oxide material, and Mn³⁺ is subjected to disproportionation reaction to cause the Mn dissolution of the spinel lithium nickel manganate oxide material, so that reduction of the Mn³⁺ content can effectively reduce the Mn dissolution.

Without affecting the effect of the present disclosure, in the step S3, organic matters and/or inorganic matters commonly used in the art can be added for coating, so that side reactions between the spinel lithium nickel manganate oxide material and the electrolyte-solution is reduced when the spinel nickel lithium manganate oxide material is used in the secondary battery.

In addition, the secondary battery, the battery module, the battery pack and the electric device of the present disclosure are described with reference to the accompanying drawings.

### Secondary Battery

In an embodiment of the present disclosure, a secondary battery is provided.

Generally, the secondary battery includes a positive electrode plate, a negative electrode plate, electrolyte, and a separator. In the charge and discharge processes of the battery, active ions are deintercalated and removed back and forth between the positive electrode plate and the negative electrode plate. The electrolyte plays a role in conducting ions between the positive electrode plate and the negative electrode plate. The separator is disposed between the positive electrode plate and the negative electrode plate, mainly playing a role in preventing short-circuit of the positive and negative electrodes and enabling the ions to pass through.

### [Positive Electrode Plate]

The positive electrode plate includes a positive electrode current collector and a positive electrode film layer provided on at least one surface of the positive electrode current collector, and the positive electrode film layer includes the spinel lithium nickel manganese oxide material disclosed by the first aspect of the present disclosure as the positive electrode active material.

As an example, the positive electrode current collector has two surfaces opposite to each other in its own thickness direction, and the positive electrode film layer is disposed on any one or both of the two opposite surfaces of the positive electrode current collector.

In some embodiments, the positive electrode current collector may be a metal foil or a composite current collector. For example, the metal foil may be an aluminum foil. The composite current collector may include a polymer material base-layer and a metal layer synthesized on at least one surface of the polymer material base-layer. The composite current collector may be formed by synthesizing a metal material (aluminum, aluminum alloy, nickel, nickel alloy, titanium, titanium alloy, silver, silver alloy, etc.) on polymer material base-material (base-material such as polypropylene (PP), polyethylene terephthalate (PET), polybutylene terephthalate (PBT), polystyrene (PS), polyethylene (PE), etc.).

In some embodiments, in addition to including the spinel lithium nickel manganese oxide material disclosed by the first aspect of the present disclosure, other positive electrode active materials can also be included. The positive electrode active material may be a positive electrode active material for a battery known in the art. As an example, the positive electrode active material may include at least one of: lithium-containing phosphate of an olivine structure, lithium transition metal oxide, or respective modified compounds thereof. However, the present disclosure is not limited to these materials, and other traditional materials that may be used as positive electrode active materials of the battery may also be used. These positive electrode active materials may be used alone or in combinations of two or more. Examples of lithium transition metal oxides may include, but are not limited to, at least one of lithium cobalt oxide (e.g., LiCoO₂), lithium nickel oxide (e.g., LiNiO₂), lithium manganese oxide (e.g., LiMnO₂, LiMn₂O₄), lithium nickel cobalt oxide, lithium manganese cobalt oxide, lithium nickel manganese oxide, lithium nickel cobalt manganese oxide (e.g., LiNi_{1/3}Co_{1/3}Mn_{1/3}O₂) (which may also be referred to as NCM₃₃₃ for short), LiNi_{0.5}Co_{0.2}Mn_{0.3}O₂ (which may also be referred to as NCM₅₂₃ for short), LiNi_{0.5}Co_{0.25}Mn_{0.25}O₂ (which may also be referred to as NCM₂₁₁ for short ), LiNi_{0.6}Co_{0.2}Mn_{0.2}O₂ (which may also be referred to as NCM₆₂₂ for short), LiNi_{0.8}Co_{0.1}Mn_{0.1}O₂ (which may also be referred to as NCM₈₁₁ for short), lithium nickel cobalt aluminum oxide (e.g., LiNi_{0.85}Co_{0.15}Al_{0.05}O₂), or modified compounds thereof. Examples of lithium-containing phosphates of olivine structures may include, but are not limited to, at least one of lithium iron phosphate (such as LiFePO₄ (which may also be referred to as LFP for short)), a composite material of lithium iron phosphate and carbon, lithium manganese phosphate (such as LiMnPO₄), a composite material of lithium manganese phosphate and carbon, lithium iron manganese phosphate, or a composite material of lithium iron manganese phosphate and carbon.

In some embodiments, the positive electrode film layer further optionally includes a binding agent. As an example, the binding agent may include at least one of polyvinylidene fluoride (PVDF), polytetrafluoroethylene (PTFE), vinylidene fluoride-tetrafluoroethylene-propylene terpolymer, vinylidene fluoride-hexafluoropropylene-tetrafluoroethylene terpolymer, tetrafluoroethylene-hexafluoropropylene copolymer, or fluorine-containing acrylate resin.

In some embodiments, the positive electrode film layer further optionally includes a conductive agent. As an example, the conductive agent may include at least one of superconducting carbon, acetylene black, carbon black, Ketjen black, carbon dots, carbon nanotubes, graphene, or carbon nanofibers.

In some embodiments, the positive electrode plate may be prepared by a manner below: dispersing components used for preparing the positive electrode plate, such as the positive electrode active material, the conductive agent, the binding agent and any other components in a solvent (such as N-methylpyrrolidone), to form positive electrode slurry; coating the positive electrode slurry on the positive electrode current collector, and drying, cold pressing and performing other processes, to obtain the positive electrode plate.

### [Negative Electrode Plate]

The negative electrode plate includes a negative electrode current collector and a negative electrode film layer disposed on at least one surface of the negative electrode current collector, and the negative electrode film layer includes a negative electrode active material.

As an example, the negative electrode current collector has two surfaces opposite to each other in its own thickness direction, and the negative electrode film layer is disposed on any one or both of the two opposite surfaces of the negative electrode current collector.

In some embodiments, the negative electrode current collector may be a metal foil or a composite current collector. For example, the metal foil may be a copper foil. The composite current collector may include a polymer material base-layer and a metal layer synthesized on at least one surface of the polymer material base-material. The composite current collector may be formed by synthesizing a metal material (copper, copper alloy, nickel, nickel alloy, titanium, titanium alloy, silver, silver alloy, etc.) on a polymer material base-material (base-material such as polypropylene (PP), polyethylene terephthalate (PET), polybutylene terephthalate (PBT), polystyrene (PS), polyethylene (PE), etc.).

In some embodiments, the negative electrode active material may be a negative electrode active material for a battery known in the art. As an example, the negative electrode active material may include at least one of: artificial graphite, natural graphite, soft carbon, hard carbon, silicon-based material, tin-based material, lithium titanate, and the like. The silicon-based material may be at least one selected from elemental silicon, silicon-oxygen compound, silicon-carbon composite, silicon-nitrogen compound, or silicon alloy. The tin-based material may be at least one selected from elemental tin, tin oxide compound, or tin alloy. However, the present disclosure is not limited to these materials, and other traditional materials that may be used as the negative electrode active materials of the battery may also be used. These negative electrode active materials may be used alone or in combinations of two or more.

In some embodiments, the negative electrode film layer further optionally includes a binding agent. The binding agent may be at least one selected from styrene butadiene rubber (SBR), polyacrylic acid (PAA), sodium polyacrylate (PAAS), polyacrylamide (PAM), polyvinyl alcohol (PVA), sodium alginate (SA), polymethacrylic acid (PMAA), or carboxymethyl chitosan (CMCS).

In some embodiments, the negative electrode film layer further optionally includes a conductive agent. The conductive agent may be at least one selected from superconducting carbon, acetylene black, carbon black, Ketjen black, carbon dots, carbon nanotubes, graphene, or carbon nanofibers.

In some embodiments, the negative electrode film layer may optionally include other additives, such as a thickening agent (such as sodium carboxymethyl cellulose (CMC-Na)), or the like.

In some embodiments, the negative electrode plate may be prepared by a following manner: dispersing components for preparing the negative electrode plate, such as the negative electrode active material, the conductive agent, the binding agent, and any other components in a solvent (for example, deionized water) to form a negative electrode slurry; coating the negative electrode slurry on the negative electrode current collector, and drying, cold pressing and performing other processes, to obtain the negative electrode plate.

### [Electrolyte]

The electrolyte plays a role in conducting ions between the positive electrode plate and the negative electrode plate. The present disclosure does not specifically limit a type of the electrolyte, and the type of the electrolyte may be selected according to requirements. For example, the electrolyte may be in a liquid state, a gel state, or an all-solid state.

In some embodiments, the electrolyte is electrolyte-solution. The electrolyte-solution includes an electrolyte salt and a solvent.

In some embodiments, the electrolyte salt may be at least one selected from lithium hexafluorophosphate, lithium tetrafluoroborate, lithium perchlorate, lithium hexafluoroarsenate, lithium bis (fluorosulfonyl) imide, lithium bis (trifluoromethanesulfonyl) imide, lithium trifluoromethanesulfonate, lithium difluorophosphate, lithium difluoroborate, lithium bis(oxalate) borate, lithium difluorobisoxalato phosphate, or lithium tetrafluorooxalate phosphate.

In some embodiments, the solvent may be at least one selected from fluoroethylene carbonate, ethylene carbonate, propylene carbonate, methyl ethyl carbonate, diethyl carbonate, dimethyl carbonate, propylene carbonate, methyl carbonate, ethylene carbonate and butylene carbonate, fluoroethylene carbonate, methyl formate, methyl acetate, ethyl acetate, propyl acetate, methyl propionate, ethyl propionate, propyl propionate, methyl butyrate, ethyl butyrate, 1,4-butyrolactone, sulfolane, dimethyl sulfone, methyl ethyl sulfone, or diethyl sulfone.

In some embodiments, the electrolyte-solution further optionally includes an additive. For example, the additive may include a negative electrode film-forming additive and a positive electrode film-forming additive, and it may further include additives capable of improving certain performances of the battery, such as additives for improving an overcharge performance of the battery, additives for improving a high-temperature or low-temperature performance of the battery, and the like.

### [Isolation Film]

In some embodiments, the secondary battery further includes a separator. A type of the separator is not particularly limited in the present disclosure, and any well-known porous structure separator with good chemical stability and mechanical stability can be selected.

In some embodiments, a material of the separator may be at least one selected from glass fiber, non-woven fabric, polyethylene, polypropylene, or polyvinylidene fluoride. The separator may be a single-layer film or may be a multi-layer composite film, which is not particularly limited. When the separator is the multi-layer composite film, materials of the layers may be the same or different, which is not particularly limited.

In some embodiments, the positive electrode plate, the negative electrode plate, and the separator may be made into an electrode assembly by means of a winding process or a lamination process.

In some embodiments, the secondary battery may include an outer package. The outer package may be configured to encapsulate the electrode assembly and the electrolyte above.

In some embodiments, the outer package of the secondary battery may be a hard housing, such as a hard plastic housing, an aluminum housing, a steel housing, and the like. The outer package of the secondary battery may also be a soft package, such as a bag-type soft package. A material of the soft package may be plastic, and the plastic may be polypropylene, polybutylene terephthalate, polybutylene succinate, and the like.

A shape of the secondary battery is not particularly limited in the present disclosure, and it can be cylindrical, square, or any other shape. For example, FIG. 3 is a secondary battery 5 having a square structure as an example.

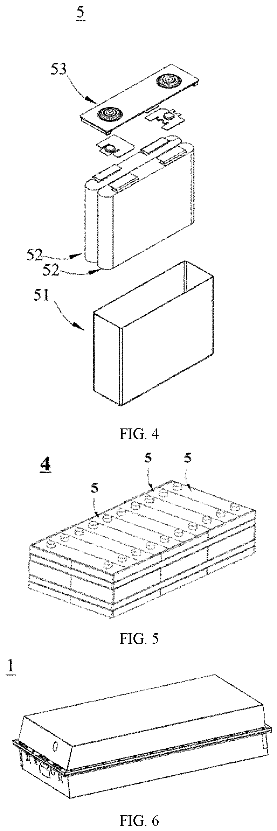

In some embodiments, referring to FIG. 4, the outer package may include a housing 51 and a cover plate 53. The housing 51 may include a bottom plate and a side plate connected to the bottom plate, and the bottom plate and the side plate enclose to form an accommodating cavity. The housing 51 has an opening in communication with the accommodating cavity, and the cover plate 53 can be disposed to cover the opening in order to close the accommodating cavity. The positive electrode plate, the negative electrode plate, and the separator may form an electrode assembly 52 through a winding process or a lamination process. The electrode assembly 52 is encapsulated in the accommodating cavity. The electrode assembly 52 is infiltrated in the electrolyte-solution. Number of the electrode assembly 52 contained in the secondary battery 5 may be one or more, and those skilled in the art may select according to specific actual requirements.

### Battery Module

In some embodiments, the secondary battery may be assembled into a battery module, and number of the secondary battery contained in the battery module may be one or more, specific number of which may be selected by those skilled in the art according to an application and a capacity of the battery module.

FIG. 5 shows a battery module 4 as an example. Referring to FIG. 5, in the battery module 4, a plurality of the secondary batteries 5 may be sequentially arranged along a length direction of the battery module 4. Certainly, they can also be arranged in any other manner. The plurality of the secondary batteries 5 can be further fixed by fasteners.

Optionally, the battery module 4 may further include an outing shell having an accommodating space, and the plurality of the secondary batteries 5 are accommodated in the accommodating space.

### Battery Pack

In some embodiments, the battery module above can also be assembled into a battery pack, and number of the battery module contained in the battery pack can be one or more, specific number of which can be selected by those skilled in the art according to an application and a capacity of the battery pack.

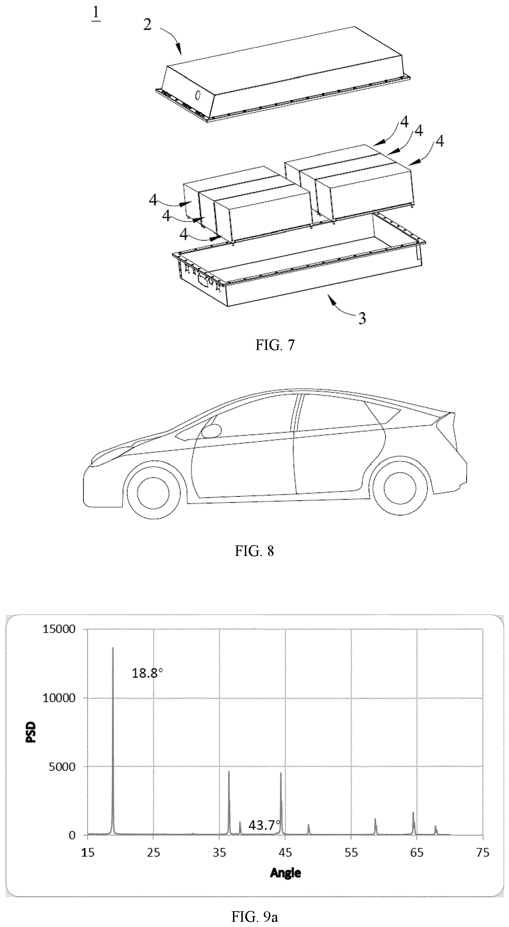

FIG. 6 and FIG. 7 show a battery pack 1 as an example. Referring to FIG. 6 and FIG. 7, the battery pack 1 can include a battery box and a plurality of the battery modules 4 arranged in the battery box. The battery box includes an upper box body 2 and a lower box body 3, and the upper box body 2 can be disposed to cover the lower box body 3 to form a closed space for accommodating the battery modules 4. The plurality of the battery modules 4 can be arranged in the battery box in any manner.

### Electric Device

In addition, the present disclosure further provides an electric device, and the electric device includes at least one of the secondary battery, the battery module or the battery pack provided by the present disclosure. The secondary battery, the battery module, or the battery pack can be used as a power supply for the electric device and can also be used as an energy storage unit of the electric device. The electric device may include a mobile device (such as a mobile phone, a notebook computer, etc.), an electric vehicle (such as a pure electric vehicle, a hybrid electric vehicle, a plug-in hybrid electric vehicle, an electric bicycle, an electric scooter, an electric golf cart, an electric truck, etc.), an electrical train, a ship, a satellite, an energy storage system, etc., but it is not limited thereto.

The electric device may select the secondary battery, the battery module or the battery pack according to use requirements thereof.

FIG. 8 shows an electric device as an example. The electric device is a pure electric vehicle, a hybrid electric vehicle, a plug-in hybrid electric vehicle and the like. In order to meet requirements of the electric device for high power and high energy density of the secondary battery, a battery pack or a battery module can be adopted.

A device as another example can be a mobile phone, a tablet computer, a notebook computer and the like. The device is usually required to be light and thin, and the secondary battery can be used as a power supply.

### Embodiments

The embodiments of the present disclosure are described below. The embodiments described below are exemplary and only used for explaining the present disclosure, and cannot be understood as limitation to the present disclosure. Specific techniques or conditions, which are not specified in the embodiments, are carried out in accordance with techniques or conditions described in literature in the art or in accordance with a specification of a product. Adopted reagents or instruments, which are not noted with manufacturers, are all conventional products which are commercially available.

### < Embodiment 1 >

The spinel lithium nickel manganese oxide material of Embodiment 1 is prepared according to steps S1 to S3 below.

Step S1: placing lithium carbonate (lithium salt), 3.5µ nickel manganese hydroxide (nickel manganese hydroxide precursor) and niobium oxide (M-containing compound) into an inclined mixer (a mixer) and mixing, to obtain a mixed material, and ensuring that a molar ratio of Li/(Ni + Mn) to be 0.53:1, where (Ni + Mn) represents a total number of moles of metals nickel and manganese, and Nb is doped in an amount according to a molar ratio of Li/M of 1:0.004.

Step S2: in an oxygen-enriched atmosphere with oxygen content of 95%, in an in-furnace pressure being 0.03Mpa or less, heating the mixed material obtained in the step S1 to 1000°C at a heating rate of 1°C/min to carry out the first sintering for 30 hours, naturally cooling to a room temperature after the first sintering is finished, and then carrying out ball milling to obtain powder.

Step S3: in the oxygen-enriched atmosphere with the oxygen content of 95%, in the in-furnace pressure being 0.03Mpa or less again, heating the powder obtained in the step S2 to 700°C at the heating rate of 1°C/min to carry out the second sintering for 10 hours, holding this temperature for 10 hours after the second sintering is finished, then naturally cooling to the room temperature, and then carrying out ball milling to obtain the spinel lithium nickel manganate oxide material.

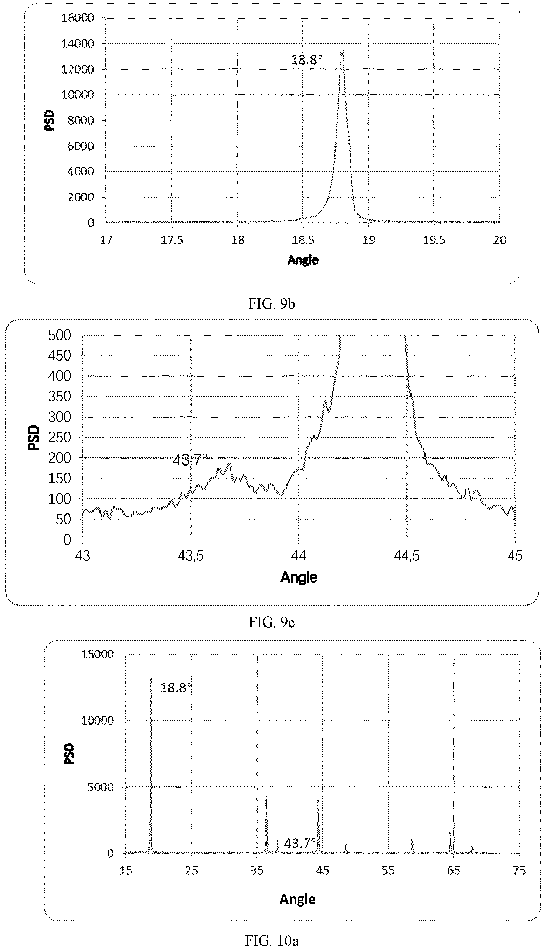

It is confirmed that the stoichiometric formula of the spinel lithium nickel manganese oxide material is Li(Ni_{0.5}Mn_{1.5})_{0.996}M_{0.004}O₄, and the spinel lithium nickel manganese oxide material obtained by the Embodiment 1 has a diffraction peak appearing in the vicinity of 43.7° and a diffraction peak appearing in the vicinity of 18.8°, as shown in FIG. 9a, FIG. 9b and FIG.9c, so that a peak area of the diffraction peak appearing in the vicinity of 43.7° and a peak area of the diffraction peak appearing in the vicinity of 18.8° are obtained, so as to determine that (A(43.7°)/A(18.8°))^{1/2} of the spinel lithium nickel manganese oxide material obtained in the Embodiment 1 is in the scope of the present disclosure.

In addition, specific conditions in a preparation process of the Embodiment 1, and a specific stoichiometric formula, a crystal structure, physicochemical data and an electrical property of the spinel lithium nickel manganese oxide material obtained by preparation are respectively shown in Table 1 and Table 2.

### < Embodiments 2 to 12 >

In the Embodiments 2 to 12, the same preparation method as that in the Embodiment 1 is adopted, and a difference lies in that the specific conditions in the preparation process are respectively changed, specifically as shown in Table 1, and a specific stoichiometric formula, a crystal structure, physicochemical data, an electrical property and the like of the spinel lithium nickel manganese oxide material obtained by preparation are also respectively shown in Table 1 and Table 2.

### <Comparative Examples 1 to 12 >

In the Comparative Examples 1 to 12, the same preparation method as that in the Embodiment 1 is adopted, and a difference lies in that the specific conditions in the preparation process are respectively changed, specifically as shown in Table 1, and a specific stoichiometric formula, a crystal structure, physicochemical data, an electrical property and the like of the spinel lithium nickel manganese oxide material obtained by preparation are also respectively shown in Table 1 and Table 2.

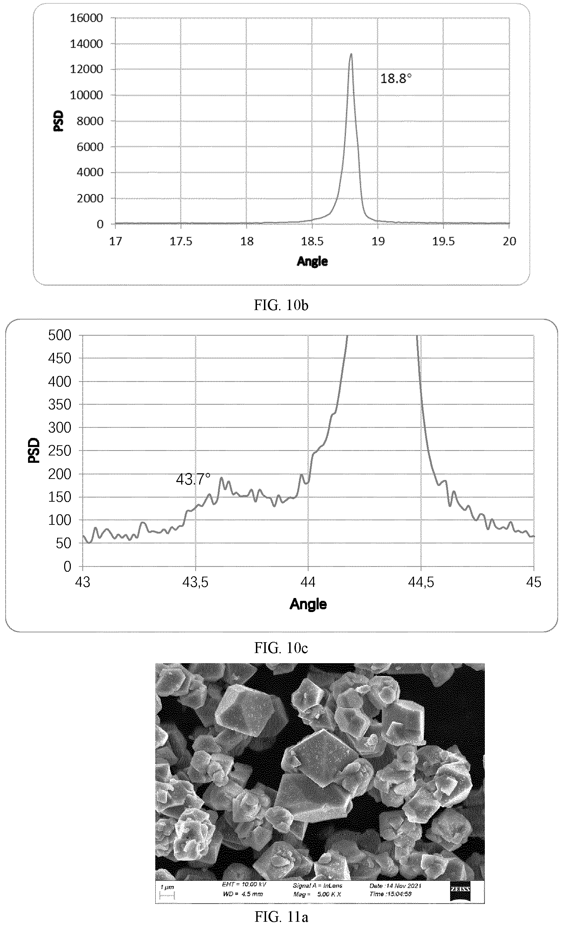

In addition, the spinel lithium nickel manganese oxide material obtained by the Comparative Example 1 has a diffraction peak appearing in the vicinity of 43.7° and a diffraction peak appearing in the vicinity of 18.8°, as shown in FIG. 10a, FIG. 10b and FIG. 10c, so that a peak area of the diffraction peak appearing in the vicinity of 43.7° and a peak area of the diffraction peak appearing in the vicinity of 18.8° are obtained, so as to determine that (A(43.7°)/A(18.8°))^{1/2} of the spinel lithium nickel manganese oxide material obtained in the Comparative Examples 1 is out of the scope of the present disclosure.

A testing process of related parameters involved in the Embodiments 1 to 12 and the Comparative Examples 1 to 12 of the present disclosure are described in detail below.

### I. XRD Spectrum of Spinel Lithium Nickel Manganese Oxide Material

Equipment Model: Bruker X-ray diffractometer D8 DISCOVER, and Reference Standard Process: JIS K0131-1996 general rules for X-ray diffractometric analysis.

A specific process is: (1) sample preparation: using a sample cell with a depth of 1mm and a diameter of 25mm, to prepare a sample through a flat plate sample preparation method; (2) testing: a starting angle of 15°, an ending angle of 70°, a step length of 0.01671°, and duration of each step for 0.24s; and (3) fixed core parameters: voltage of 40 KV, Current of 40mA, and anti-scattering slit of 1mm, measuring the spinel lithium nickel manganate oxide material obtained in the Embodiments 1 to 12 and the Comparative Examples 1 to 12 according to the specific processes (1) to (3).

Then data is processed with X'Pert HighScore Plus to obtain A(43.7°) (i.e., the peak area of the diffraction peak appearing in the vicinity of 43.7° in the XRD spectrum) and A(18.8°) (i.e., the peak area of the diffraction peak appearing in the vicinity of 18.8° in the XRD spectrum), so as to determine (A(43.7°)/A(18.8°))^{1/2}.

### II. Test of Volume Median Particle Size (D50)

Equipment Model: Malvern Panalytical 3000 (MasterSizer 3000) laser particle size analyzer, and Reference Standard Process: GB/T19077-2016/ISO 13320:2009, Specific test process: taking a proper amount of a to-be-tested sample (sample concentration is ensured to be 8% to 12% light obscuration), adding 20ml of deionized water, simultaneously carrying out external-super for 5min (53KHz/120W) to ensure that the sample is completely dispersed, and then measuring the spinel lithium nickel manganate oxide material obtained in the Embodiments 1 to 12 and the Comparative Samples 1 to 12 according to GB/T19077-2016/ISO 13320:2009. The measurement results are shown in Table 2.

### III. Determining Particle Volume Distribution Span (Dv90-Dv10)/Dv50)

When testing the volume median particle size (D50), Dv90 and Dv10 are also obtained, and then this value is determined through a calculation formula (Dv90-Dv10)/Dv50. The measurement results are shown in Table 2.

### IV. Test of Particle Morphology of Spinel Lithium Nickel Manganese Oxide Material

The spinel lithium nickel manganese oxide material obtained by the Embodiments 1 to 12 and the Comparative Examples 1 to 12 are tested by using a ZEISS sigma 300 scanning electron microscope, then testing is carried out by referring to Standard JY/T010-1996, to observe morphology of the sample. The measurement results are shown in Table 2.

### V. Test of Specific Surface Area (BET)

An American Micromeritics multi-station full-automatic specific surface area and pore analyzer Gemini VII 2390 is used, about 7g of sample of the spinel nickel lithium manganate oxide material obtained in the Embodiments 1 to 12 and the Comparative Examples 1 to 12 is taken and placed into a 9cc long tube having a bulb, degassing is carried out at 150°C for 15min, and then it is placed into a host for testing to obtain BET data. The measurement results are shown in Table 2.

### VI. Test of Battery Performance

The spinel lithium nickel manganese oxide material obtained by the Embodiments 1 to 12 and the Comparative Examples 1 to 12 is subjected to a battery performance test below. The measurement results are shown in Table 2.

### Assembly of Button-Type Half-battery

The spinel lithium nickel manganese oxide material prepared from the Embodiments 1 to 12 and the Comparative Examples 1 to 12 as a positive electrode active material is mixed with conductive carbon black and PVDF according to a weight ratio of 90:5:5, a proper amount of N-methyl pyrrolidone is added and uniformly stirred, to obtain positive electrode slurry. The positive electrode slurry is coated on an aluminum foil and dried, to obtain the positive electrode plate. A loading capacity of the positive electrode active material on the positive electrode plate is 0.015g/cm².

The mixed solution of carbonic ester containing 1 mol/L of LiPF₆, phosphate and the like is taken as the electrolyte-solution.

A polypropylene film (Φ16mm) with a thickness of 12µm is used as a separator, and a lithium plate, the separator and the positive electrode plate are placed sequentially, to make the separator play a role in isolation between the metal lithium plate and a composite negative electrode plate. The electrolyte-solution is injected, to assemble a CR2030 button-type battery, and it is left to stand for 24 hours, to obtain the button-type half-battery.

### (1) Discharge Capacity of Button Battery

At 25°C, the button-type half-battery prepared by taking the spinel lithium nickel manganese oxide material obtained from the various Embodiments 1 to 12 and the Comparative Examples 1 to 12 as the positive electrode active material is charged to a voltage of 4.95V at a constant current of 0.1C, then charged at a constant voltage of 4.95V until the current is 0.05C, and after standing for 5 minutes, the button-type half-battery is discharged to a voltage of 3.5V at the constant current of 0.1C.

### Preparation of Graphite Soft Package Battery

The spinel lithium nickel manganese oxide material prepared from the Embodiments 1 to 12 and the Comparative Examples 1 to 12 as the positive electrode active material is mixed with the conductive carbon black and the PVDF according to the weight ratio of 96:2.5:1.5, a proper amount of N-methyl pyrrolidone is added and uniformly stirred, to obtain positive electrode slurry. The positive electrode slurry is coated on an aluminum foil and dried, to obtain the positive electrode plate. A loading capacity of the positive electrode active material on the positive electrode plate is 0.02g/cm².

The graphite is mixed with conductive carbon black and carboxymethyl cellulose according to a weight ratio of 96:1:3, a proper amount of pure water is added and uniformly stirred, to obtain negative electrode slurry. The negative electrode slurry is coated on the copper foil and dried, to obtain the negative electrode plate. A loading capacity of the graphite on the negative electrode plate is 0.008g/cm².

The mixed solution of carbonic ester containing 1mol/L of LiPF₆, phosphate and the like is used as the electrolyte-solution.

A polypropylene film (Φ16mm) with a thickness of 12µm is used as a separator, the positive electrode plate, the separator and the negative electrode plate are sequentially placed, to make the separator play a role in isolation between the positive and negative electrode plates, after winding and forming, and it is packaged with an aluminum-plastic bag. The electrolyte-solution is injected, after packaging and then carrying out formation capacity, the graphite soft package battery is obtained.

### (2) Soft Package for 300cls/% Cycles at 25°C

The graphite soft package battery obtained by taking the spinel lithium nickel manganese oxide material prepared from the various Embodiments 1 to 12 and the Comparative Examples 1 to 12 as the positive electrode active material is a test object.

At 25°C, the graphite soft package battery is charged at a constant current of 0.3C until a voltage is 4.9V, then it is charged to the current of 0.05C at a constant voltage of 4.9V, after standing for 5 minutes, and the graphite soft package battery is discharged to the voltage of 3.5V at a constant current of 0.33C, which is one charge and discharge cycle process, and a discharge capacity for this time is the discharge capacity of the first charge and discharge cycle. After 300 times of cyclic charge and discharge tests are carried out on the full battery according to the method above, residual reversible discharge capacity is recorded.

### (3) Soft Package for 200cls/% Cycles at 45°C

The graphite soft package battery obtained by taking the spinel lithium nickel manganese oxide material prepared from the various Embodiments 1 to 12 and the Comparative Examples 1 to 12 as the positive electrode active material is a test object.

At 45°C, the graphite soft package battery is charged at a constant current of 0.3C until a voltage is 4.9V, then it is charged to the current of 0.05C at a constant voltage of 4.9V, after standing for 5 minutes, and the graphite soft package battery is discharged to the voltage of 3.5V at a constant current of 0.33C, which is one charge and discharge cycle process, and a discharge capacity for this time is the discharge capacity of the first charge and discharge cycle. After 200 times of cyclic charge and discharge tests are carried out on the full battery according to the method above, residual reversible discharge capacity is recorded.

### (4) Soft Package being Fully-Charged and Stored at 45°C(d)

The graphite soft package battery obtained by taking the spinel lithium nickel manganese oxide material prepared from the various Embodiments 1 to 12 and the Comparative Examples 1 to 12 as the positive electrode active material is a test object.

At 25°C, the graphite soft package battery is charged at the constant current of 0.3C until the voltage is 4.9V, then the battery is charged at the constant voltage of 4.9V until the current is 0.05C. Then the soft package battery is left to stand at 45°C, and after one discharge process is performed every 5d, it is fully charged again and continues to store in an environment of 45°C. A discharge capacity value is extracted until the discharge capacity is attenuated to 80% of an initial value, then storage ends. The total duration stored at 45°C after fully charged is high-temperature full-charge storage duration. The charge and discharge process is the same as a charge and discharge process of a full-capacitance test (5).

### (5) Full Capacitance

The graphite soft package battery obtained by taking the spinel lithium nickel manganese oxide material prepared from the various Embodiments 1 to 12 and the Comparative Examples 1 to 12 as the positive electrode active material is a test object.

At 25°C, the graphite soft package battery is charged at the constant current of 0.3C until the voltage is 4.9V, then it is charged at the constant voltage of 4.9V until the current is 0.05C, and after standing for 5min, the graphite soft package battery is discharged to a voltage of 3.5V at the constant current of 0.33C, and this discharge capacity is the full capacitance of the soft package.

**Table 1**

| | Step S1 | Step S1 | Step S2, Step S3 | Step S2, Step S3 | Step S2, Step S3 | Step S2 | Step S3 | Step S3 | Stoichiometric Formula of Spinel Lithium Nickel Manganese Oxide Material |
|---|---|---|---|---|---|---|---|---|---|
| | Doping Element M | Doping Amount Li/M | Heating Rate (°C/min) | Oxygen Content (%) | In-furnace Pressure (Mpa) | Temperature for First Sintering (°C) | Temperature for Second Sintering (°C) | Time for Holding Temperature (h) | Liₓ(Ni_{0.5}Mn_{1.5})ₙMₘO₄ |
| Embodiment 1 | Nb | 1:0.004 | 1 | 95 | 0.03 | 1000 | 700 | 10 | Li(Ni_{0.5}Mn_{1.5})_{0.996}M_{0.004}O₄ |
| Embodiment 2 | Nb | 1:0.003 | 1 | 95 | 0.03 | 1000 | 700 | 10 | Li(Ni_{0.5}Mn_{1.5})_{0.997}M_{0.003}O₄ |
| Embodiment 3 | Nb | 1:0.007 | 1 | 95 | 0.03 | 1000 | 700 | 10 | Li(Ni_{0.5}Mn_{1.5})_{0.993}M_{0.007}O₄ |
| Embodiment 4 | Nb | 1:0.004 | 3 | 95 | 0.03 | 1000 | 700 | 10 | Li(Ni_{0.5}Mn_{1.5})_{0.996}M_{0.004}O₄ |
| Embodiment 5 | Nb | 1:0.004 | 1 | 80 | 0.03 | 1000 | 700 | 10 | Li(Ni_{0.5}Mn_{1.5})_{0.996}M_{0.004}O₄ |
| Embodiment 6 | Nb | 1:0.004 | 1 | 95 | 0.02 | 1000 | 700 | 10 | Li(Ni_{0.5}Mn_{1.5})_{0.996}M_{0.004}O₄ |
| Embodiment 7 | Nb | 1:0.004 | 1 | 95 | 0.04 | 1000 | 700 | 10 | Li(Ni_{0.5}Mn_{1.5})_{0.996}M_{0.004}O₄ |
| Embodiment 8 | Nb | 1:0.004 | 1 | 95 | 0.03 | 1000 | 500 | 10 | Li(Ni_{0.5}Mn_{1.5})_{0.996}M_{0.004}O₄ |
| Embodiment 9 | Nb | 1:0.004 | 1 | 95 | 0.03 | 1000 | 600 | 10 | Li(Ni_{0.5}Mn_{1.5})_{0.996}M_{0.004}O₄ |
| Embodiment 10 | Nb | 1:0.004 | 1 | 95 | 0.03 | 1000 | 700 | 5 | Li(Ni_{0.5}Mn_{1.5})_{0.996}M_{0.004}O₄ |
| Embodiment 11 | Nb | 1:0.004 | 1 | 95 | 0.03 | 1000 | 700 | 30 | Li(Ni_{0.5}Mn_{1.5})_{0.996}M_{0.004}O₄ |
| Embodiment 12 | w | 1:0.004 | 1 | 95 | 0.03 | 1000 | 700 | 10 | Li(Ni_{0.5}Mn_{1.5})_{0.996}M_{0.004}O₄ |
| Comparative Example 1 | Nb | 1:0.0005 | 1 | 95 | 0.03 | 1000 | 700 | 10 | Li(Ni_{0.5}Mn_{1.5})_{0.9995}M_{0.0005}O₄ |
| Comparative Example 2 | Nb | 1:0.012 | 1 | 95 | 0.03 | 1000 | 700 | 10 | Li(Ni_{0.5}Mn_{1.5})_{0.988}M_{0.012}O₄ |
| Comparative | Nb | 1:0.004 | 10 | 95 | 0.03 | 1000 | 700 | 10 | Li(Ni_{0.5}Mn_{1.5})_{0.996}M_{0.004}O₄ |
| Example 3 | | | | | | | | | |
| Comparative Example 4 | Nb | 1:0.004 | 1 | 50 | 0.03 | 1000 | 700 | 10 | Li(Ni_{0.5}Mn_{1.5})_{0.996}M_{0.004}O₄ |
| Comparative Example 5 | Nb | 1:0.004 | 1 | 95 | 0.01 | 1000 | 700 | 10 | Li(Ni_{0.5}Mn_{1.5})_{0.996}M_{0.004}O₄ |
| Comparative Example 6 | Nb | 1:0.004 | 1 | 95 | 0.1 | 1000 | 700 | 10 | Li(Ni_{0.5}Mn_{1.5})_{0.996}M_{0.004}O₄ |
| Comparative Example 7 | Nb | 1:0.004 | 1 | 95 | 0.03 | 1000 | 300 | 10 | Li(Ni_{0.5}Mn_{1.5})_{0.996}M_{0.004}O₄ |
| Comparative Example 8 | Nb | 1:0.004 | 1 | 95 | 0.03 | 1000 | 800 | 10 | Li(Ni_{0.5}Mn_{1.5})_{0.996}M_{0.004}O₄ |
| Comparative Example 9 | Nb | 1:0.004 | 1 | 95 | 0.03 | 1000 | 700 | 3 | Li(Ni_{0.5}Mn_{1.5})_{0.996}M_{0.004}O₄ |
| Comparative Example 10 | Nb | 1:0.004 | 1 | 95 | 0.03 | 1000 | 700 | 50 | Li(Ni_{0.5}Mn_{1.5})_{0.996}M_{0.004}O₄ |
| Comparative Example 11 | Zr | 1:0.004 | 1 | 95 | 0.03 | 1100 | 700 | 10 | Li(Ni_{0.5}Mn_{1.5})_{0.996}M_{0.004}O₄ |
| Comparative Example 12 | Ti | 1:0.004 | 1 | 95 | 0.03 | 1100 | 700 | 10 | Li(Ni_{0.5}Mn_{1.5})_{0.996}M_{0.004}O₄ |

**Table 2**

| physicochemical data | | | | | | | Electrical Properties | | | |
|---|---|---|---|---|---|---|---|---|---|---|
| | Button Battery Discharge Capacity 3.0 to 4.95 | (A(43.7°)/ A(18.8°))^{1/2} | DV50 | (Dv90-Dv10)/ Dv50 | Particle Morphology | BET | Capacity Retention Rate of Soft Package for 300cls/% Cycles at 25°C /% 3.5 to 4.9 | Capacity Retention Rate of Soft Package for 200cls/% Cycles at 45°C /% 3.5 to 4.9 | Soft Package being Fully Charged and Stored at 45°C(d) | Full Capacitance |
| Embodiment 1 | 135.6 | 0.0569 | 8.5 | 0.69 | Passivated Single Crystal | 0.453 | 91.4 | 85.8 | 221 | 130.6 |
| Embodiment 2 | 136.4 | 0.1 | 8.2 | 0.77 | Passivated Single Crystal | 0.443 | 90.7 | 85 | 214 | 131.4 |
| Embodiment 3 | 134.6 | 0.1 | 11.2 | 0.63 | Passivated Single Crystal | 0.416 | 89.2 | 84.6 | 208 | 131.1 |
| Embodiment 4 | 135.1 | 0.1 | 7.9 | 0.87 | Passivated Single Crystal | 0.583 | 88.5 | 83.1 | 215 | 130.1 |
| Embodiment 5 | 135.4 | 0.0832 | 8.8 | 0.74 | Passivated Single Crystal | 0.437 | 87.7 | 82.8 | 209 | 130.4 |
| Embodiment 6 | 135.2 | 0.0684 | 7.9 | 0.88 | Passivated Single Crystal | 0.369 | 88.3 | 83.8 | 205 | 130.2 |
| Embodiment 7 | 134.8 | 0.0598 | 8.4 | 0.95 | Passivated Single Crystal | 0.895 | 89.5 | 84.5 | 212 | 129.8 |
| Embodiment 8 | 137.8 | 0.152 | 8.6 | 0.62 | Passivated Single Crystal | 0.451 | 89.2 | 84.8 | 209 | 132.8 |
| Embodiment 9 | 137.5 | 0.869 | 8.3 | 0.79 | Passivated Single Crystal | 0.468 | 90.8 | 85.1 | 204 | 132.5 |
| Embodiment 10 | 137.5 | 0.134 | 8.6 | 0.78 | Passivated Single Crystal | 0.442 | 87 | 82.4 | 213 | 132.5 |
| Embodiment 11 | 135.4 | 0.751 | 8.3 | 0.65 | Passivated Single Crystal | 0.458 | 91.2 | 86.4 | 207 | 130.4 |
| Embodiment 12 | 134.5 | 0.096 | 8.2 | 0.66 | Passivated Single Crystal | 0.446 | 92.5 | 87.5 | 181 | 129.5 |
| Comparative Example 1 | 137.8 | 0.351 | 4.1 | 0.71 | Non-Passivated Single Crystal | 0.899 | 83.2 | 78.3 | 132 | 132.8 |
| Comparative Example 2 | 132.5 | 0.491 | 16.7 | 0.75 | Passivated Single Crystal | 0.411 | 86.7 | 82.3 | 126 | 127.5 |
| Comparative Example 3 | 134.2 | 0.214 | 8.3 | 1.54 | Passivated Single Crystal | 0.115 | 82.9 | 77.2 | 187 | 129.2 |
| Comparative Example 4 | 134.3 | 0.225 | 8.5 | 0.75 | Passivated Single Crystal | 0.446 | 82.6 | 77.9 | 200 | 129.3 |
| Comparative Example 5 | 136.6 | 0.0741 | 8.0 | 1.36 | Passivated Single Crystal | 0.109 | 86.1 | 81.5 | 175 | 131.6 |
| Comparative Example 6 | 136.8 | 0.0623 | 7.5 | 1.43 | Passivated Single Crystal | 1.398 | 81.8 | 76.6 | 152 | 131.8 |
| Comparative Example 7 | 138.5 | 0.351 | 8.1 | 0.73 | Passivated Single Crystal | 0.435 | 84.4 | 79.3 | 173 | 133.5 |
| Comparative Example 8 | 135.7 | 0.254 | 8.3 | 0.71 | Passivated Single Crystal | 0.449 | 83.4 | 78.4 | 234 | 130.7 |
| Comparative Example 9 | 137.2 | 0.314 | 8.7 | 0.64 | Passivated Single Crystal | 0.439 | 85.6 | 80.7 | 165 | 132.2 |
| Comparative Example 10 | 135 | 0.662 | 8.5 | 0.64 | Passivated Single Crystal | 0.425 | 91.6 | 86.8 | 231 | 130 |
| Comparative Example 11 | 134.1 | 0.241 | 7.3 | 1.41 | Non-Passivated Single Crystal | 0.127 | 77.7 | 72.3 | 80 | 129.1 |
| Comparative Example 12 | 130.6 | 0.294 | 7.1 | 1.62 | Non-Passivated Single Crystal | 0.134 | 75.5 | 70.8 | 60 | 125.6 |

It can be seen from the Table 1 and the Table 2 the content below.

According to the Embodiments 1, 2 and 3 and the Comparative Examples 1 and 2, it can be seen that an over-dose doping amount can greatly influence the full-battery capacitance and the button-battery capacitance of the material, and will influence the circulation thereof to a certain extent, while a too small doping amount will greatly influence the structural stability thereof and reduce an effect of the passivated octahedron, resulting in increase of the side reaction, which is indicated by reduction of the storage and cycle performance.

According to the Embodiments 1 and 4 and the Comparative Examples 1 and 3, it can be seen that an excessive heating rate enables consistency of the particle size to be reduced, that is, the value of the (Dv90-Dv10)/Dv50 is increased, resulting in increase of the side reactions of the material and the electrolyte-solution; and meanwhile, the excessive heating rate enables the content of the oxygen defect to be increased in the particle growth process, and the structural stability thereof become poor, so that the storage and cycle performance becomes poor.

From the Embodiments 1 and 5 and the Comparative Examples 1 and 4, it can be seen that the oxygen content mainly affects the content of the oxygen defect of the material, and a lower oxygen content can lead to a relatively large content of the oxygen defect, thereby affecting the storage and cycle performance thereof.

As can be seen from the Embodiments 1, 6, and 7 and the Comparative Examples 1, 5, and 6, the in-furnace pressure mainly affects the value of (Dv90-Dv10)/Dv50 and the BET size of the material, and the too large or too small in-furnace pressure results in increase of the small particles, thereby making the (Dv90-Dv10)/Dv50 and the BET be too large, and thus increasing the side reactions of the material.

According to the Embodiments 1, 8 and 9 and the Comparative Examples 1, 7 and 8, it can be seen that the second sintering process is a process of compensating oxygen defects, and the effect is extremely low if the temperature for the second sintering annealing is too low, and the oxygen defect is increased if the temperature for the second sintering is too high.

According to the Embodiments 1, 10 and 11 and the Comparative Examples 1, 9 and 10, it can be seen that a too short time for holding the temperature after second sintering cannot achieve the effect of compensating oxygen defects, while prolonging the time for holding the temperature outside the range will not further reduce the oxygen defect, and on the contrary, the process cost is increased.

According to the Embodiments 1 and 12 and the Comparative Examples 1, 11 and 12, it can be seen that except the doping elements in the range, other elements cannot achieve effects of passivating octahedron, promoting primary particle growth and the like, thereby losing effects of improving the structural stability of the material, reducing the content of the oxygen defect, the side reactions and the transition metal Mn dissolution.

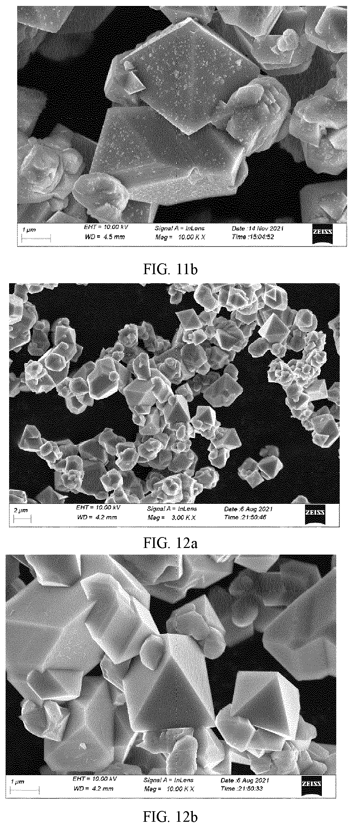

Further, as shown in FIG. 11a, FIG. 11b and FIG. 12a and FIG. 12b, FIG. 11a and FIG. 11b show a lithium nickel manganese oxide material doped with Zr in the Comparative Example 11, and FIG. 12a and FIG. 12b show a lithium nickel manganese oxide material without doping, it can be seen that even if the lithium nickel manganese oxide material is doped, but what is doped is other element (such as Zr) outside the range of the present disclosure, the effects of passivating octahedron and promoting primary particle growth can still not be achieved.

In conclusion, by comparing the Embodiments 1 to 12 and the Comparative Examples 1 to 12, it can be known that the spinel lithium nickel manganese oxide material has advantages that the content of the oxygen defect is low, the stability of the crystal structure is high, the content of the rock salt phase is low, then the secondary battery using the spinel lithium nickel manganese oxide material has a high energy density and a long cycle life, and a gas production problem in the cycle process is effectively inhibited.

It should be noted that the present disclosure is not limited to the above-mentioned embodiments. The above embodiments are merely examples, and embodiments having substantially the same composition as that of technical ideas and playing the same effect in the range of the technical solution of the present disclosure are all included in the technical scope of the present disclosure. In addition, without departing from the spirit of the present disclosure, various modifications which are applied to the embodiments and can be conceived of by those skilled in the art, and other manners constructed by combining part of the components in the embodiments are also included within the scope of the present disclosure.

## Claims

1. A spinel lithium nickel manganese oxide material, wherein,
an X-ray diffraction (XRD) pattern of the spinel lithium nickel manganese oxide material satisfies: 0 < (A(43.7°)/A(18.8°))^{1/2} ≤ 0.2,
where A(43.7°) represents a peak area of a diffraction peak appearing in the vicinity of 43.7° in the XRD pattern, and A(18.8°) represents a peak area of a diffraction peak appearing in the vicinity of 18.8° in the XRD pattern.

2. The spinel lithium nickel manganese oxide material according to claim 1, wherein,
the crystal structure satisfies: 0 < (A(43.7°)/A(18.8°))^{1/2} ≤ 0.1.

3. The spinel lithium nickel manganese oxide material according to claim 1 or claim 2, wherein,
a stoichiometric formula of the spinel lithium nickel manganese oxide material is Liₓ(Ni_{0.5}Mn_{1.5})ₙMₘO₄,
where M is one or more elements selected from W, P, B, Nb, Mo or Ta, and as stoichiometric numbers, n + m = 1, x is in a range from 0.95 to 1.1, and m is in a range from 0.001 to 0.015.

4. The spinel lithium nickel manganese oxide material according to any one of claims 1 to 3, wherein,
the spinel lithium nickel manganese oxide material is a single crystal of an octahedron with corners of obtuse angles.

5. The spinel lithium nickel manganese oxide material according to any one of claims 1 to 4, wherein,
a volume distribution average particle size Dv50 of the spinel lithium nickel manganese oxide material is in a range from 5µm to 15µm.

6. The spinel lithium nickel manganese oxide material according to claim 5, wherein,
the volume distribution average particle size Dv50 of the spinel lithium nickel manganese oxide material is in a range from 5µm to 10µm.

7. The spinel lithium nickel manganese oxide material according to any one of claims 1 to 6, wherein,
a particle volume distribution span (Dv90-Dv10)/Dv50 of the spinel lithium nickel manganese oxide material is 1.0 or less.

8. The spinel lithium nickel manganese oxide material according to any one of claims 1 to 7, wherein,
a BET specific surface area of the nickel manganese spinel material is in a range from 0.3m²/g to 1.0m²/g.

9. The spinel lithium nickel manganese oxide material according to claim 8, wherein,
the BET specific surface area of the nickel manganese spinel material is in a range from 0.3m²/g to 0.5m²/g.

10. A preparation method of the spinel lithium nickel manganese oxide material of any one of claims 1 to 9, the preparation method comprising:
step S1: putting a lithium salt, a nickel manganese hydroxide precursor and an M-containing compound into a mixer for mixing to obtain a mixed material;
step S2: heating the mixed material obtained in the step S1 in an oxygen-enriched atmosphere for first sintering, naturally cooling to a room temperature after the first sintering is finished, and then carrying out ball milling to obtain a powder; and
step S3: heating the powder obtained in the step S2 in an oxygen-enriched atmosphere again for second sintering, holding a temperature after the second sintering is finished, then naturally cooling to the room temperature, and then carrying out ball milling to obtain the spinel lithium nickel manganate oxide material.

11. The preparation method of the spinel lithium nickel manganese oxide material according to claim 10, wherein,
in the step S1, the lithium salt and the nickel manganese hydroxide are mixed in a molar ratio of Li/(Ni + Mn) of (0.45 to 0.55):1, where (Ni + Mn) represents a total number of moles of metals nickel and manganese, and
the M-containing compound is doped in an amount according to a molar ratio of Li/M of 1:(0.001 to 0.01).

12. The preparation method of the spinel lithium nickel manganese oxide material according to claim 11, wherein,
the M-containing compound is doped in an amount according to a molar ratio of Li/M of 1:(0.003 to 0.007).

13. The preparation method of the spinel lithium nickel manganese oxide material according to any one of claims 10 to 12, wherein,
in the step S1, the mixer is a ploughshare mixer, a high-speed mixer or an inclined mixer.

14. The preparation method of the spinel lithium nickel manganese oxide material according to any one of claims 10 to 13, wherein,
in the step S2 and the step S3, a heating rate during the first sintering and the second sintering is 5°C/min or lower.

15. The preparation method of the spinel lithium nickel manganese oxide material according to claim 14, wherein,
in the step S2 and the step S3, the heating rate during the first sintering and the second sintering is 3°C/min or lower.

16. The preparation method of the spinel lithium nickel manganese oxide material according to any one of claims 10 to 15, wherein,
In the step S2 and the step S3, an oxygen content of the oxygen-enriched atmosphere is higher than 60%.

17. The preparation method of the spinel lithium nickel manganese oxide material according to claim 16, wherein,
in the step S2 and the step S3, the oxygen content of the oxygen-enriched atmosphere is in a range from 80% to 100%.

18. The preparation method of the spinel lithium nickel manganese oxide material according to any one of claims 10 to 17, wherein,
in the step S2 and the step S3, a pressure in a sintering furnace relative to an atmospheric pressure is in a range from 0.02MPa to 0.08MPa.

19. The preparation method of the spinel lithium nickel manganese oxide material according to claim 18, wherein,
in the step S2 and the step S3, the pressure in the sintering furnace relative to the atmospheric pressure is in a range from 0.02MPa to 0.04MPa.

20. The preparation method of the spinel lithium nickel manganese oxide material according to any one of claims 10 to 19, wherein,
in the step S2, the first sintering is carried out at a temperature in a range from 500°C to 1200°C, and in the step S3, the second sintering is carried out at a temperature in a range from 400°C to 700°C.

21. The preparation method of the spinel lithium nickel manganese oxide material according to claim 19, wherein,
in the step S2, the first sintering is carried out at a temperature in a range from 600°C to 1200°C, and in the step S3, the second sintering is carried out at a temperature in a range from 500°C to 700°C.

22. The preparation method of the spinel lithium nickel manganese oxide material according to any one of claims 10 to 21, wherein,
in the step S3, a duration for holding the temperature is in a range from 5 hours to 40 hours.

23. The preparation method of the spinel lithium nickel manganese oxide material according to claim 22, wherein,
in the step S3, the duration for holding the temperature is in a range from 15 hours to 30 hours.
